Europäisches Patentamt

European Patent Office

Office européen des brevets

(11) Veröffentlichungsnummer : **0 352 424 B1**

(12) **EUROPÄISCHE PATENTSCHRIFT**

(45) Veröffentlichungstag der Patentschrift :
28.09.94 Patentblatt 94/39

(21) Anmeldenummer : **89109142.3**

(22) Anmeldetag : **20.05.89**

(51) Int. Cl.$^5$ : **H01L 39/24, H01L 39/14**

(54) **Kabel mit keramischem Supraleiter.**

(30) Priorität : **05.07.88 DE 3822684**

(43) Veröffentlichungstag der Anmeldung :
**31.01.90 Patentblatt 90/05**

(45) Bekanntmachung des Hinweises auf die
Patenterteilung :
**28.09.94 Patentblatt 94/39**

(84) Benannte Vertragsstaaten :
**DE FR GB IT**

(56) Entgegenhaltungen :
**EP-A- 0 285 952**
**EP-A- 0 301 279**
**EP-A- 0 301 283**

(56) Entgegenhaltungen :
**FUJIKURA TECHNICAL REVIEW, Nr. 17, Februar 1988, Seiten 1-4, Tokyo, JP; H.OSANAI et
al.: "High temperature superconducting oxide
wires"**
**ELECTRONIC ENGINEERING, Band 60, Nr.
741, September 1988, Seite 25, Woolwich,GB;
J. EVETTS et al.: "High Tc superconductors at
Cambridge"**
**APPLIED PHYSICS LETTERS, Band 51, Nr. 3,
20. Juli 1987, Seiten 203 - 204**
**JOURNAL OF METALS, Band 39, Mai 1987,
Seiten 8 - 10**
**SIEMENS-ZEITSCHRIFT, 61. Jahrgang, Nr. 6,
November/Dezember 1987, Seiten 34 - 37**

(73) Patentinhaber : **ASEA BROWN BOVERI AG**
**Haselstrasse 16**
**CH-5401 Baden (CH)**

(72) Erfinder : **Dersch, Helmut, Dr.**
**Chilesteig 45**
**CH-8116 Würenlos (CH)**

## Beschreibung

Bei der Erfindung wird ausgegangen von einem Kabel mit einem keramischem Supraleiter nach dem Oberbegriff des Patentanspruchs 1.

Mit dem Oberbegriff des Patentanspruchs 1 nimmt die Erfindung auf die EP-A1-0 301 283 Bezug, die bezüglich der Länder Deutschland, Frankreich und Großbritannien als Stand der Technik gilt. Dort ist ein Verfahren zur Herstellung eines ummantelten Drahtes aus einem keramischen Hochtemperatursupraleiter angegeben, bei dem mehrere Filamentleiter aus supraleitendem Material mit einem Durchmesser von ca. 0,8 mm in einen als Notstromleiter dienenden Silberkörper eingebettet sind. Der Silberkörper ist von einer Nickelhülle als mechanischer Stütze und Korrosionsschutz allseitig umschlossen. Inmitten mehrerer Filamentleiter befindet sich jeweils eine Bohrung mit einer sauerstoffabgebenden Substanz. In dieser Druckschrift sind auch Einzeldrähte beschrieben, bei denen Supraleiter-Ausgangspulver in ein Silberrohr eingebracht wird, welches von einer Diffusionsperre gegen Sauerstoff, bestehend aus Nickel, Tantal, Niob oder Vanadium oder einer Legierung mindestens 2er dieser Elemente, umgeben ist. Dieses Rohr mit der Diffusionssperre ist von einem Kupferrohr umschlossen.

Ein ähnlich aufgebautes, supraleitendes Kabel ist aus der EP-A2-0 285 952 bekannt, die ebenfalls bezüglich der Länder Deutschland, Frankreich und Großbritannien als Stand der Technik gilt. Dort sind mikroskopisch dünne Filamentsupraleiter in einem elektrischen Leiter z. B. aus Kupfer angeordnet. Dieser Kupferblock ist von einem Mantel aus einer Eisen-Nickellegierung umschlossen.

Durch S. Jin u. a., High $T_c$ superconductors - composite wire fabrication, Appl. Phys. Lett. 51, (3), 20 July 1967, S. 203 und 204, ist ein Verfahren zur Herstellung eines Drahtes mit einem Hochtemperatursupraleiter mit einem Durchmesser im Bereich von 0,25 mm - 1,55 mm bekannt, bei dem pulverisiertes Supraleiter-Ausgangsmaterial in ein Silberrohr oder in ein Kupferrohr mit einer Ni/Au-Diffusionsbarriere eingebracht wird.

Nachteilig bei diesen supraleitenden Drähten ist, daß das Eigenmagnetfeld des stromdurchflossenen Leiters schon bei relativ kleinen Strömen die Supraleitung zum Erliegen bringt.

Es ist bekannt, Supraleiter des Typs $SEBa_2Cu_3O_{6,5-7}$ durch Bereitstellen und Mischen von Pulvern der Ausgangsmaterialien und anschliessender Wärmebehandlung herzustellen. Als Ausgangsmaterialien werden in der Regel $Y_2O_3/CuO$ und $BaO$ oder $BaCO_3$ verwendet. Im Falle von $BaCO_3$ muss das $CO_2$ durch einen zusätzlichen Kalzinierungsprozess ausgetrieben werden (vgl. T. Kawai and M. Kanai, "Preparation of high-Tc Y-Ba-Cu-O Superconductor", Jap. Journal of Applied Physics, Vol. 26, No. 5, May 1987, pp. L736-L737; Y.Yamada, N.Fukuschima, S.Nakayama and S.Murase, "Critical current density of wire type Y-Ba-Cu-Oxide superconductor", Jap. Journal of Applied Physics, Vol. 26, No. 5, May 1987, pp. L865-L866). Dabei wird in sauerstoffhaltiger Atmosphäre (Luft) gesintert, also unter einem gewissen $O_2$-Partialdruck. Dadurch steuert die umgebende Sinteratmosphäre ihren Beitrag zur Erreichung eines leicht überstöchiometrischen Sauerstoffgehalts der Verbindung bei. Es ist auch schon vorgeschlagen worden, den Sinterprozess in einem Silberröhrchen durchzuführen. Silber ist für elementaren Sauerstoff durchlässig, so dass letzterer durch Diffusion in das Kernmaterial hineingelängt (vgl. H. Yoshino, N. Fukushima, M. Niu, S. Nakayama, Y. Yamada and S. Murase, "Superconducting wire and coil with zero resistance state at 90 K and current density of 510 A/cm² at 77 K", Toshiba Corporation, R+D Center, Saiwai-ku, Kawasaki-City 210, Japan).

Keramische Hochtemperatur-Supraleiter zeichnen sich durch eine verhältnismässig niedrige kritische Stromdichte aus, was ihrer allgemeinen Verwendung entgegensteht. Offenbar genügen bereits schwache Magnetfelder, um die Supraleitung zum Erliegen zu bringen. Dazu genügt zum Beispiel schon das Eigen-Magnetfeld des stromdurchflossenen Leiters. Gegenwärtig verfügbares keramisches Material ist immer durch diesen Eigenfeldeffekt begrenzt.

Die Erfindung, wie sie im Patentanspruch 1 definiert ist, löst die Aufgabe, einen elektrischen Leiter in Draht- oder Kabelform auf der Basis eines keramischen Hochtemperatur-Supraleiters anzugeben, der eine bessere Stromtragfähigkeit aufweist und bei welchem der schädliche Einfluss des Eigen-Magnetfeldes auf die kritische Stromdichte $j_{crit}$ weitgehend unterdrückt ist. Der Leiter soll sich auf einfache Art mit reproduzierbaren physikalischen Eigenschaften mit grosser Längenabmessung herstellen lassen.

Die Erfindung wird anhand der nachfolgenden, durch Figuren näher erläuterten Ausführungsbeispiele beschrieben. Dabei zeigt:

Fig. 1    einen schematischen Querschnitt durch einen Draht (Grundaufbau eines Einfachfilamentleiters), der keine Ausführungsform der Erfindung darstellt; und

Fig. 2    einen schematischen Querschnitt durch einen Mehrfachfilamentleiter.

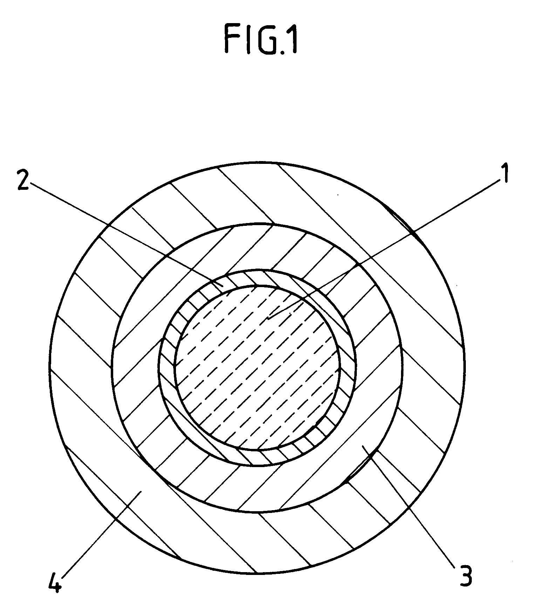

In Fig. 1 ist ein schematischer Querschnitt durch einen Draht (Grundaufbau) im Zustand der Endform, d.h. nach dem Walzen, Schmieden, Rundhämmern, Ziehen etc. dargestellt. 1 ist der Kern aus supraleitendem Material, z.B. aus Keramik des Typs $SEBa_2Cu_3O_{6,5+y}$ mit SE = seltenes Erdmetall und $0<y<1$. 2 ist eine Diffusionsperre, welche aus Tantal, Niob, Vanadium, Nickel etc. bestehen kann und die Abwanderung des Sauerstoffs aus dem Kernmaterial (Supraleiterkörper 1) weitgehend unterbindet. Natürlich kann die Diffusionssperre 2 auch aus einer Legierung mindestens zweier dieser Elemente bestehen. 3 ist ein Metallmantel, z.B. ein Kupfer- oder Silberrohr, der als mechanischer Träger zur Wahrung der geometrischen Form und als elektrischer Notstromleiter dient. 4 ist ein weicher Magnetwerkstoff hoher Permeabilität, welcher den Kern 1 und den Metallmantel 3 konzentrisch umschliesst und das Eigenmagnetfeld des mit einem elektrischen Strom beaufschlagten Leiters quasi in sich "hineinsaugt".

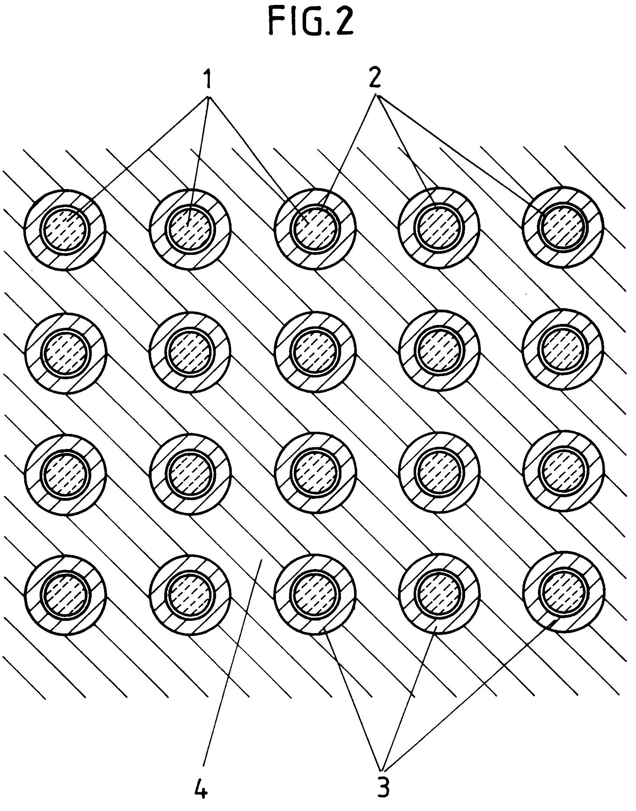

Fig. 2 stellt einen schematischen Querschnitt durch einen Mehrfachfilamentleiter dar. Es handelt sich um ein Bündel paralleler Fasern, deren Grundaufbau demjenigen der Fig. 1 entspricht. Die Bezugzeichen sind genau die gleichen wie diejenigen dieser Figur. Die einzelnen Leiter sind im weichen Magnetwerkstoff 4 fest eingebettet.

Ausführungsbeispiel 1:

Siehe Fig. 1 und 2!

Für den Kern 1 aus supraleitendem Material wurde eine Zusammensetzung gewählt, die der Formel

$$YBa_2Cu_3O_7$$

entsprach.

Zu diesem Zweck wurde ein hohlzylindrischer Metallmantel 3 in Form eines Kupferrohres von 5 mm Innendurchmesser und 8 mm Aussendurchmesser (1,5 mm Wandstärke) innen mit einer 200 µm dicken Nickelschicht als Diffusionssperre 2 versehen. Das Kupferrohr wurde nun mit einer Pulvermischung gefüllt, die das nachfolgende Mengenverhältnis aufwies:

| | |
|---|---|
| 1 Mol | $Y_2O_3$ |
| 3 Mol | $BaO$ |
| 1 Mol | $BaO_2$ |
| 6 Mol | $CuO$ |

In einen prismatischen Block aus weichem Magnetwerkstoff 4 - im vorliegenden Fall weicher Stahl - wurden in einem Abstand von 12 mm Löcher von 8 mm Durchmesser gebohrt. In diese Löcher wurden mit der Pulvermischung gefüllte Rohrabschnitte eingesetzt. Der prismatische Stahlblock wurde durch Kaliberwalzen auf ca. 1/16 seines ursprünglichen Querschnitts reduziert, wobei die mit supraleitendem Material 1 gefüllten Löcher noch einen Durchmesser von ca. 1,25 mm hatten. Dann wurde die auf diese Weise hergestellte Stange von ca. 50 mm Durchmesser durch mehrmaliges Ziehen sukzessive in ihrem Durchmesser auf 5 mm reduziert und nach mehrmaligem Zwischenglühen auf einen Draht von 1 mm Durchmesser heruntergezogen. Die einzelnen Filamente hatten dabei einen Durchmesser von ca. 25 µm angenommen. Nach der endgültigen Formgebung wurde der gewickelte Draht in eine Anlage zum heissisostatischen Pressen gebracht, die mit Argon geflutet wurde. Der Druck wurde bis 20 MPa (200 bar) gesteigert und die Temperatur sukzessive während einer Dauer von 10 h auf 930 °C erhöht. Dieser Zustand wurde während 4 h gehalten, dann wurde der Mehrfachfilamentleiter mit einer Geschwindigkeit von 25 K/h auf Raumtemperatur abgekühlt. Durch die Glühbehandlung wurde durch reaktives Sintern die supraleitende Verbindung $YBa_2Cu_3O_7$ gebildet.

Ein Vergleich mit einem kompakten Supraleiter von 1 mm Durchmesser, ohne weichmagnetisches Einbettungsmaterial ergab folgendes Bild:
Die Stromtragfähigkeit des kompakten Drahtes betrug ca. 5 A, was einer kritischen Stromdichte von ca. 600 A/cm² entsprach. Die Stromtragfähigkeit des Mehrfachfilamentleiters betrug hingegen ca. 20 A, was also der 4 fachen Stromdichte des ungeschützten Materials entspricht. Dabei können folgende Ueberlegungen gelten:
Neuere Forschungen zeigen, dass die starke Magnetfeldabhängigkeit begrenzender Faktor des kritischen Stroms ist. Das Material verliert seine supraleitende Eigenschaft, wenn das Eigenmagnetfeld H des Stroms einen kritischen Wert übersteigt, der typischerweise 16 A/cm (20 Oe) beträgt. Daraus folgt, dass ein Filament eine umso grössere Stromdichte $j_{crit}$ tragen kann, je kleiner der Radius R ist, denn das maximale Eigenfeld beträgt $H = j_{crit} \cdot \dfrac{2\pi}{C} \cdot R$. Dies wird experimentell gefunden. Eine ähnliche Ueberlegung zeigt, dass dünne Filme ebenfalls höhere Stromdichten transportieren können als dicke Filme.

Das magnetische Feld in einem Filament setzt sich zusammen aus dem Eigenfeld $H_e$ und dem Gesamtfeld $H_g$ der anderen Filamente. $H_g$ ist maximal am Rand des Kabels und beträgt dort 159 A/cm (200 Oe). Durch die magnetische Abschirmung wird dieser Wert reduziert um einen Faktor, der für die gegenwärtige Geometrie etwa $\mu/5$ beträgt ($\mu$ ist die Permeabilität des magnetischen Materials). Für weichen Stahl ergibt sich hier ein typischer Wert $\mu/5 = 20$ für $H = 159$ A/cm (200 Oe), d.h. $H_g$ im Filament beträgt 8 A/cm (10 Oe). Zu berechnen bleibt das Eigenfeld: Jedes Filament muss bei einem Gesamtstrom von 20 A einen Strom von 16 mA tragen. Für einen Filamentdurchmesser von 25 µm ergibt das ein Feld von 0,3 A/cm (4 Oe). Das Maximalfeld wird also nie grösser als 11 A/cm (10 Oe + 4 Oe = 14 Oe).

Ausführungsbeispiel 2:

Siehe Fig. 1 und 2!

Für den Kern 1 aus supraleitendem Material wurde eine Zusammensetzung gewählt, die der Formel

$$YBa_2Cu_3O_{7+x} \text{ mit } -0,5 < x < 0,1$$

entsprach.

Als Ausgangsmaterialien wurden Oxidpulver verwendet. Die Pulvermischung wies folgendes Mengenverhältnis auf:

| | |
|---|---|
| 1 Mol | $Y_2O_3$ |
| 2 Mol | BaO |
| 2 Mol | $BaO_2$ |
| 6 Mol | CuO |

Dies würde einer hypothetischen Verbindung der Formel

$$YBa_2Cu_3O_{7,5}$$

entsprechen.

Ein als Metallmantel 3 dienendes Silberrohr von 5 mm Innendurchmesser und 9 mm Aussendurchmesser (2 mm Wandstärke) wurde innen mit einer 20 μm dicken Tantalschicht als Diffusionssperre 2 versehen und in ein Nickelrohr 4 von 9 mm Innendurchmesser und 13 mm Aussendurchmesser gesteckt. Dann wurden 7 Rohre zu einem Bündel zusammengefasst (Bündeldurchmesser ca. 39 mm). Die Rohre wurden mit der Pulvermischung gefüllt und das ganze Bündel durch Kalibrierwalzen bei 850 °C auf einen Durchmesser von ca. 5 mm reduziert. Dabei verschweissten die Nickelrohre zu einer kompakten Masse, welche den weichen Magnetwerkstoff 4 bildete. Das Bündel wurde daraufhin durch mehrmaliges Ziehen mit Zwischenglühen auf einen Durchmesser von 1 mm reduziert. Je 7 derartige Bündel wurden wieder vereinigt und auf einen Durchmesser von 1 mm heruntergezogen. Dann wurden nochmals 7 der letzten Bündel vereinigt und auf einen Enddurchmesser von ca. 1,4 mm heruntergezogen. Die einzelnen Filamente hatten noch einen Durchmesser von ca. 20 μm. Dann wurde der Mehrfachfilamentleiter in die endgültige gewickelte Form gebracht und einem reaktiven Sinterprozess unterworfen. Das Glühen erfolgte unter Sauerstoffatmosphäre von 100 MPa (1000 bar) während 8 h bei einer Temperatur von 920 °C. Dann wurde zunächst langsam bis auf 500 °C abgekühlt und dann rasch auf Raumtemperatur abgekühlt. Die Untersuchung zeigte, dass der Mehrfachfilamentleiter eine Stromtragfähigkeit hatte, die einer kritischen Stromdichte von ca. 2500 A/cm$^2$ entsprach.

Für die Ueberlegungen gelten die unter Beispiel 1 gemachten Angaben.

Die Erfindung ist nicht auf die Ausführungsbeispiele beschränkt. Grundsätzlich besteht der elektrische Leiter in Draht- oder Kabelform aus einem Mehrfachfilamentleiter auf der Basis eines keramischen Hochtemperatur-Supraleiters des Typs $SEBa_2Cu_3O_{6,5+y}$, wobei SE ein seltenes Erdmetall und $0<y<1$ bedeutet, oder des Typs $(La,Ba,Sr)_2CuO_4$ und der besagte Supraleiter als Kern in einem als mechanischer Träger und Notstromleiter dienenden Metallmantel angeordnet ist, wobei der mit dem Metallmantel versehene Kern eines jeden Filamentes des in eine Vielzahl von Filamenten aufgelösten elektrischen Leiters in einen weichen Magnetwerkstoff hoher Permeabilität eingebettet ist. Für letzteren sind Fe, Ni und/oder deren Legierungen geeignet, wobei die Permeabilität mindestens 10 betragen soll, während die Sättigung der magnetischen Induktion mindestens 0,2 T beträgt.

Der elektrische Leiter wird als Mehrfachfilamentleiter mit einem Durchmesser der einzelnen Kerne von 2 μm bis 200 μm ausgebildet, welche eine gemeinsame allseitig geschlossene Einbettung in Form eines zusammenhängenden weichen Magnetwerkstoffs besitzen.

Zwischen Metallmantel und Kern wird vorteilhafterweise eine Diffusionssperre für Sauerstoff eingebaut.

Der Vorteil der Erfindung besteht in der gegenüber unabgeschirmten draht- oder kabelförmigen Hochtemperatur-Supraleitern um den Faktor 4 erhöhten kritischen Grenzstromdichte. Auch die Stromtragfähigkeit im Falle von Wechselstrombetrieb wird durch die magnetische Abschirmung wesentlich erhöht.

## Patentansprüche

1. Elektrischer Leiter in Draht- oder Kabelform,
   a) der mehrere Filamentleiter umfaßt,
   b) wobei jeder Filamentleiter einen Kern (1) aus einem keramischen Hochtemperatursupraleiter aufweist,
   c) der mit einem als mechanischem Träger und Notstromleiter dienenden Metallmantel (3) ummantelt ist,
   dadurch gekennzeichnet,

d) daß jeder Filamentleiter separat in einen für alle Filamentleiter gemeinsamen Block aus einem weichmagnetischen Werkstoff eingebettet ist, der jeden Filamentleiter umhüllt,

e) dessen Permeabilität mindestens 10 und

f) dessen Sättigung der magnetischen Induktion mindestens 0,2 T beträgt.

2. Elektrischer Leiter nach Anspruch 1, dadurch gekennzeichnet,

a) daß der weichmagnetische Werkstoff aus Eisen oder

b) Nickel oder

c) aus einer Eisen- oder Nickellegierung besteht.

3. Elektrischer Leiter nach Anspruch 1 oder 2, dadurch gekennzeichnet, daß jeder der Kerne (1) einen Durchmesser im Bereich von 2 $\mu$m - 200 $\mu$m hat.

4. Elektrischer Leiter nach einem der Ansprüche 1 bis 3, dadurch gekennzeichnet, daß zwischen Kern (1) und Metallmantel (3) eines jeden Filamentleiters eine Diffusionssperre (2) für Sauerstoff angeordnet ist.

5. Elektrischer Leiter nach einem der Ansprüche 1 bis 4, dadurch gekennzeichnet,

a) daß der Hochtemperatursupraleiter die Zusammensetzung $SEBa_2Cu_3O_{6,5+y}$ oder

b) $(La, Ba, Sr)_2CuO_4$ aufweist,

wobei SE ein seltenes Erdmetall und $0 < y < 1$ ist.

## Claims

1. Electrical conductor in wire or cable form,

a) which comprises a plurality of filament conductors,

b) each filament conductor having a core (1) consisting of a ceramic high-temperature superconductor,

c) which is sheathed with a metal sheath (3) which serves as mechanical carrier and emergency current conductor,

characterized in that

d) each filament conductor is embedded separately in a block which is common for all the filament conductors and which consists of a soft magnetic material which surrounds each filament conductor,

e) whose permeability is at least 10 and

f) whose saturation of the magnetic induction is at least 0.2 T.

2. Electrical conductor according to Claim 1, characterized in that

a) the soft magnetic material is composed of iron or

b) nickel or

c) an iron or nickel alloy.

3. Electrical conductor according to Claim 1 or 2, characterized in that each of the cores (1) has a diameter in the range of 2 $\mu$m to 200 $\mu$m.

4. Electrical conductor according to any of Claims 1 to 3, characterized in that a diffusion barrier (2) for oxygen is arranged between core (1) and metal sheath (3) of every filament conductor.

5. Electrical conductor according to one of Claims 1 to 4, characterized

a) in that

the high-temperature superconductor has the composition $SEBa_2Cu_3O_{6,5+y}$ or

b) $(La, Ba, Sr)_2CuO_4$,

SE being a rare-earth metal and $0 < y < 1$.

## Revendications

1. Conducteur électrique sous forme de fil ou de câble,

a) qui comprend plusieurs conducteurs à filaments,

b) chaque conducteur à filaments présentant un coeur (1) fait d'un supraconducteur haute température en céramique,

c) qui est enveloppé d'une enveloppe métallique (3) servant de support mécanique et de conducteur de secours,

caractérisé en ce que

d) chaque conducteur à filaments est noyé séparément dans un bloc commun à tous les conducteurs à filaments, fait d'un matériau magnétique doux, qui entoure chaque conducteur à filament,

e) dont la perméabilité est au moins de 10 et

f) dont la saturation de l'induction magnétique est d'au moins 0,2 T.

2. Conducteur électrique selon la revendication 1, caractérisé en ce que

a) le matériau magnétique doux se compose de fer ou

b) de nickel ou

c) d'un alliage en fer ou en nickel.

3. Conducteur électrique selon la revendication 1 ou 2, caractérisé en ce que chacun des coeurs (1) a un diamètre dans le domaine de 2 microns - 200 microns.

4. Conducteur électrique selon l'une quelconque des revendications 1 à 3, caractérisé en ce qu'entre coeur (1) et enveloppe métallique (3) de chaque conducteur à filaments est disposée une barrière de diffusion (2) pour l'oxygène.

5. Conducteur électrique selon l'une quelconque des revendications 1 à 4, caractérisé en ce que

a) le supraconducteur haute température présente la composition $TRBa_2Cu_3O_{6,5+y}$ ou

b) $(La, Ba, Sr)_2CuO_4$, TR étant une terre rare et y étant tel que $0 < y < 1$.

# FIG.1

# FIG.2